# EUROPEAN PATENT APPLICATION

(11) **EP 3 264 105 A1**
(43) Date of publication of application: **03.01.2018**
(21) Application number: 16305814.2
(22) Date of filing: 30.06.2016
(51) Int. Cl.: G01Q 30/20, G02B 21/34, H01J 37/20, H02S 50/10

(54) **SAMPLE HOLDER FOR SURFACE AND/OR CROSS-SECTION MICROSCOPY ANALYSIS OF A SOLID SAMPLE**

(71) Applicant: Total S.A., 92400 Courbevoie (FR); Electricité de France (EDF), 75008 Paris (FR); Centre National de la Recherche Scientifique, 75016 Paris (FR); École Polytechnique, 91120 Palaiseau (FR); Institut Photovoltaïque d'Ile de France - IPVF, 92160 Antony (FR)
(72) Inventor: NARCHI, Paul, 75015 Paris (FR); FARCI, Frédéric, 91440 Bures-sur-Yvette (FR)
(74) Representative: Jacobacci Coralis Harle

(57) **Abstract**

The invention concerns sample holder (1).

According to the invention, that the sample holder (1) comprises a sample receiving portion (5) rigidly linking a first portion (101) to a second portion (102), the first portion (101) comprising means for mechanically maintaining a holding surface (2) in contact with a portion of back-side surface (12) of the sample (10), the first portion (101, 201, 301) integrating at least one connector (7, 17, 19) configured for transmitting electric energy or electro-magnetic energy generated by an excitation source, to one or several areas of the front-side surface (11) and/or back-side surface (12) of the sample (10) and said sample holder (1, 21, 31) comprising at least one outer bearing surface (108) arranged for positioning said sample (10) in a microscope instrument for analysis on said front-side surface (11), back-side surface (12) and/or on a cross-section of the sample (10).

## Description

### TECHNICAL FIELD OF THE INVENTION

The invention relates to an apparatus and a method for testing or measuring electric and/or optical properties of a solid sample, such as optical, electric or photoelectric sample devices, including photovoltaic cells (or PV cells), light emitting diodes, optical storage devices and photo-detectors. More precisely, the invention relates to an arrangement for analyzing a thin-film photoelectric device by optical microscope, electronic microscope, near-field or scanning probe microscope under defined and reproducible operation conditions of electric polarization and light illumination. The invention aims at providing microscopy analysis of optical, electric or photoelectric materials or devices during their manufacture or treatment.

The invention relates in particular to a system and method for measuring electric and/or optical properties of a thin-film solar cell on a surface and/or in cross-section. More specifically the invention relates to a system and method providing micrometric, sub-micrometric or even nanometric spatial resolution, with a high reproducibility in overall mechanical, electric and optical operation conditions.

### BACKGROUND INFORMATION AND PRIOR ART

Thin-film electric or photoelectric devices generally comprise a millimeter-thick substrate, thin-films forming an electronic junction and electrodes positioned on the front side and/or on the back side of the device. In operation conditions, the front side of the device is generally exposed to an illumination beam. Some photoelectric devices have electronic junctions on opposite sides and may receive illumination from either or both sides.

Numerous documents describe devices and methods for measuring or testing thin-film solar cells using spatially resolved techniques having a micrometric or nanometric spatial resolution. Different types of microscopes may be used alone or in combination for analyzing thin-film devices. These microscopes use various excitation and detection techniques. Some microscopy imaging techniques are based on the use of an electron excitation beam, such as scanning electron microscope (SEM) and Electron Beam Induced Current (EBIC). Other microscopy imaging techniques are based on the use optical beams, such as micro-Raman spectroscopic imaging. And other techniques are based on the use of a scanning probe, such as atomic force microscopes (AFM), Kelvin probe force microscope (KFM) and conducting probe atomic force microscopy (CP-AFM). More specifically, a Kelvin probe microscope enables measuring surface potential as a function of the illumination conditions (e.g. wavelength, intensity) or measuring cross-section of a thin-film solar cell operating under illumination or voltage bias.

Cross-section microscopy analysis of a thin-film photo-electric device requires positioning a probe beam or a probe tip of a microscope on an edge or cut-off slice of the device. A thin-film photo-electric device is generally maintained in a vertical position so as to enable cross-section microscopy analysis.

Most commercial electronic, near-field and scanning probe microscopes provide a sample stage adapted for maintaining a thin sample with an adjustable tilt angle relatively to the cantilever supporting the probe tip or relatively to the excitation beam, so as to enable cross-section analysis.

The article "Investigation of multi-junction solar cells using electrostatic force Microscopy methods, M. Moczata, N. Sosa, A. Topol, T. Gotszalk, Ultramicroscopy, 141(2014) 1-8" describes different methods for measuring electric properties of a working multi-junction device structure while selecting the spectral range of illumination used to focus on an individual junction. In particular, this article describes a Kelvin probe force microscope (KPFM) comprising a microscope stage whereon a sample holder is placed. A solar-cell cross-section sample is mounted vertically in the sample holder. This solar-cell is electrically connected. A LED source is placed on the microscope stage, separately from the sample holder. The LED source illuminates the front side of the solar-cell. However, the top cleaved surface of the solar-cell also receives radiation from the LED source. Kelvin probe force microscope (KPFM) is used for measuring voltage drop across an individual junction under various operation conditions: dark; illuminated; short-circuit and biased.

However, this microscopy apparatus does not enable cross-section analysis of a thin-film optical, electric or photo-electric device under precisely controlled operational conditions of applied voltage to the electrodes of the device and of illumination applied on the front side of the device.

Moreover, scanning probe microscopy of a photo-electric device under electric polarization raises practical difficulties due to generally cumbersome electric connections liable to interfere with the probe tip or probe beam.

There is a need for an arrangement for measuring electric and/or optical properties of a thin-film solar cell on a surface and/or in cross-section which is operational both in a vacuum environment such as inside a scanning electronic microscope and in ambient environment such as inside some scanning probe microscopy setups. Besides, to perform accurate comparison between measuring techniques, there is a need to be able to bring the exact same operating conditions from one setup to another with a broad range of operating conditions.

There is a need for an apparatus for measuring electric and/or optical properties of a thin-film solar cell at the micrometer or nanometer scale as a function of variable electric and/or electro-magnetic excitation sources.

There is a need for a benchmarking apparatus for comparing the performances of a solar cell device in operative conditions when exposed to different light sources, or for comparing the electric and/or optical performances of different solar cell devices under the same operative conditions of illumination and electric polarization.

### SUMMARY OF THE INVENTION

Therefore one object of the invention is to provide a sample holder for surface and/or cross-section microscopy analysis of a solid sample having a front-side surface and a back-side surface and a cross-section extending between the front-side surface and the back-side surface.

According to the invention, the sample holder comprises a first portion and a second portion, a sample receiving portion rigidly linking the first portion to the second portion, the sample receiving portion forming a trench between the first portion and the second portion, said trench extending along a longitudinal direction, at least one of the first portion and second portion having a holding surface adjacent to the sample receiving portion, said holding surface extending in a plane including said longitudinal direction, the first portion and/or the second portion comprising means for mechanically maintaining said holding surface in contact with a portion of one of the front-side surface or back-side surface of the sample, the first portion and/or the second portion integrating at least one connector configured for transmitting electric energy and/or electro-magnetic energy generated by an excitation source, to one or several areas of the front-side surface and/or back-side surface of the sample, said sample holder comprising at least one outer bearing surface arranged for positioning said sample in said microscope instrument for microscopy analysis on said front-side surface, back-side surface and/or on said cross-section of the sample.

The sample holder of the present disclosure is adapted for nondestructive surface and/or cross-section microscopy analysis on the front side and/or back side and/or cross-section of the thin-film photo-electric device, with micrometric or sub-micrometric spatial resolution.

Within the present disclosure, an excitation source may be a primary or a secondary source of energy. For example, a primary source of electro-magnetic energy might be a light source. A secondary source of electro-magnetic energy may consist in an image of a light source formed by an optical system or may consist in an extremity of a light guiding means, such as an optical fiber, which is optically connected to a light source. A source of electric energy may comprise contact electrodes electrically connected to a power supply unit by electric connectors and electric cables or wires.

The sample holder enables applying electric and/or electro-magnetic energy generated by an external excitation source to the front-side and/or back-side surface of a sample, while providing free access to the front-side or back-side or cross-section of the sample for a near-field microscope, a scanning probe microscope, an optical microscope or an electron beam microscope.

The sample holder is compact.

One main advantage of this sample holder invention is its versatility. The sample holder is conveyable from a microscopy setup to another, enabling measurements with different setups under the exact same conditions of operation. Besides, a broad range of illumination conditions (e.g. wavelengths, modulated frequency, intensities) and electrical conditions (e.g. voltage ranges, modulated frequency) can be used and opens a large window of measurement conditions to the users.

According to particular aspects of the sample holder :
- the holding surface forms an inner wall of the trench of said sample receiving portion;
- the holding surface forms an outer surface of the first portion and/or of the second portion;
- said outer bearing surface lies in a plane perpendicular to the holding surface;

- said outer bearing surface lies in a plane parallel to the holding surface;
- the first portion comprises an optical receiver adapted for receiving a first fiber optic connector, the first fiber optic connector being adapted for being optically connected by fiber optic to a first excitation source and for emitting a first optical beam of electro-magnetic energy and wherein the first portion is adapted for directing the first optical beam perpendicularly to the holding surface;
- the sample holder further comprises an optical system integrated in the sample holder, the optical system being configured for optically transmitting and/or reflecting the optical beam between the first optical receiver and the holding surface through the sample holder ;
- the second portion further comprises a second optical receiver adapted for receiving a second fiber optic connector, the second fiber optic connector being adapted for being optically connected by fiber optic to a second excitation source and for emitting a second optical beam of electro-magnetic energy, and wherein the second connecting portion is adapted for directing the second optical beam perpendicularly to the holding surface in opposite direction to the first optical beam ;
- the first portion comprises at least a first contact electrode, the first contact electrode being configured for electrically connecting an external excitation source of electric energy with an area of the frontside surface or backside surface of the sample;
- the second portion comprises at least a second contact electrode, said second contact electrode being configured for electrically connecting another external excitation source of electric energy with another area of frontside surface or backside surface of the sample.

A further object of the invention is to provide a system for surface and/or cross-section microscopy analysis of an optical, electric or photo-electric device comprising a sample holder according to any embodiment disclosed herein for holding the solid sample, and at least one excitation source of, respectively electric energy and/or electro-magnetic energy, said excitation source being connected to at least one connector, and a microscope configured for receiving the sample holder and for surface and/or cross-section microscopy analysis on the front-side surface and/or back-side surface and/or cross-section of the solid sample.

A further object of the invention is to provide a process for surface and/or cross-section analysis of an optical, electric or photo-electric device, said process comprising the steps of:
- mechanically maintaining a holding surface of a sample holder in contact with a front-side surface of the solid sample;
- setting at least one excitation source of, respectively electric energy and/or electro-magnetic energy, said excitation source being connected respectively by electric wire or fiber optic to a respective first and/or second portion integrated in the sample holder;
- emission of said electric energy and/or electro-magnetic energy toward the connecting portion configured for transmitting the electric energy and/or electro-magnetic energy to one or several areas on the front-side surface and/or back-side surface of the solid sample, and
- surface and/or cross-section microscopy analysis on the front-side surface and/or back-side surface and/or cross-section of the solid sample.

### BRIEF DESCRIPTION OF THE DRAWING(S)

Figure 1 schematically represents a perspective view of a sample holder according to a first embodiment, without connectors and without sample;
Figure 2 schematically represents a front-side view of a sample holder according to the first embodiment;
Figure 3 represents a bottom and side view of a sample holder according to the first embodiment, with contact electrodes mounted;
Figure 4 represents a side view of a sample holder according to the first embodiment, with contact electrodes and a mounted sample;
Figure 5 represents a front view of a sample holder according to the first embodiment, with a fiber optic, contact electrodes and a mounted sample, in dark operation conditions;
Figure 6 represents the same setup as in Figure 5 under illumination conditions;
Figure 7 shows an electric cable with an electric connector;
Figure 8 shows two electric connectors;
Figure 9 shows different types of contact electrodes;
Figure 10 shows a system for measuring a photo-electric device including a power supply unit, connected by cables to a sample holder, and a light source connected to the sample holder by fiber optic;
Figure 11 schematically represents a perspective view of a sample holder according to a second embodiment, without connectors and without sample;
Figure 12 schematically represents a side view of a sample holder according to the second embodiment;
Figure 13 shows a top perspective view of a sample holder according to the second embodiment, with a sample mounted between a pair of contact electrodes;
Figure 14 schematically shows a method for cross-section microscopy on a solar cell device in operating conditions;
Figure 15 schematically shows a method for double side illumination on a double side solar cell device;
Figure 16 schematically shows a cut-view of a sample holder according to a third embodiment and a method for scanning probe microscopy on a surface of a solar cell device in operative conditions;
Figure 17 schematically shows a perspective of a sample holder according to the third embodiment without connectors and without maintaining clips;
Figure 18 schematically shows a perspective of a sample holder according to the third embodiment with sample, connectors and maintaining clips.

### DETAILED DESCRIPTION OF EXAMPLE(S)

### Device

In the present application, the same reference signs designate the same or similar elements.

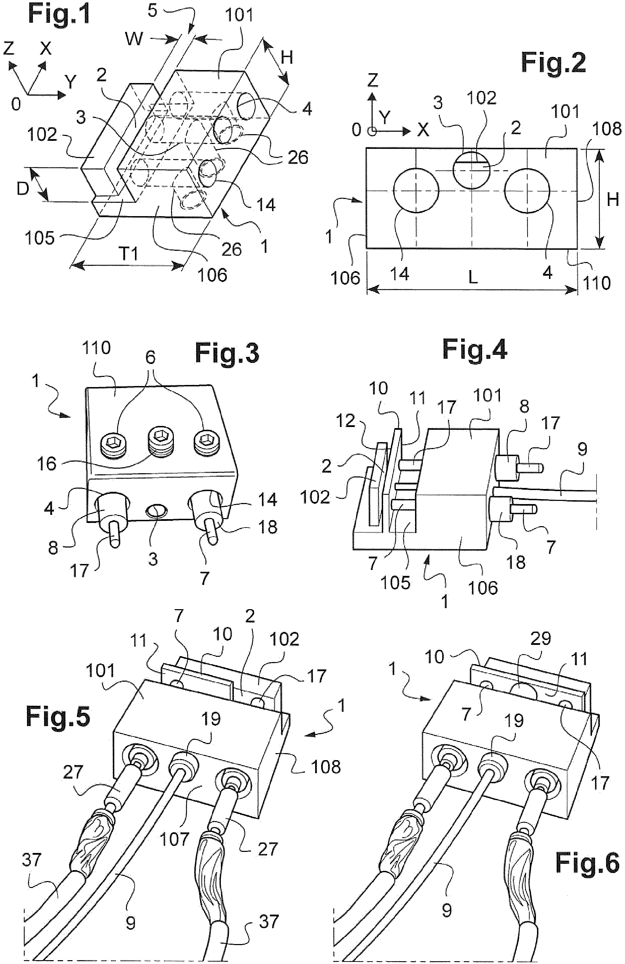

A sample holder 1 according to a first embodiment will now be described in relation with Figures 1 and 2, wherein sample holder appears from a perspective view in Fig. 1 and, respectively, from a side-view in Fig. 2. The sample holder 1 comprises a holding portion 102, a connecting portion 101 and a sample receiving portion 5 which rigidly links the holding portion 102 with the connecting portion 101. On a side-view, the sample holder 1 has generally a U-shape with a trench 5 open at both extremities and on the top. More precisely, the trench 5 has a generally parallelepiped shape and extends between the holding portion 102 and connecting portion 101.The trench 5 has a bottom surface 105. The sample receiving portion 5 is adapted for receiving a thin-film photo-electric device or a sample of such a device at an intermediate or final manufacturing step. Such a sample generally comprises a front-side surface, a back-side surface 12 and a cross-section.

According to the present disclosure, the connecting portion 101 is adapted to receive at least one connector, the connector being selected among an electric connector linked to an electric excitation source by electric cabling means or, respectively, and a fiber optic connector linked to an electro-magnetic excitation source by fiber optic means, and said connector is adapted for conducting an electric or, respectively an electro-magnetic, excitation source to the sample receiving portion 5 in the direction of the holding portion 102.

More precisely, Figure 2 shows a side-view of a sample holder according to the first embodiment, as viewed from the connecting portion 101 in the direction of the holding portion 102. The connecting portion 101 comprises through holes 3, 4, 14 arranged opposite to the inner flat surface 2 of the holding portion 102. For example, the through hole 3 is configured for receiving an optical connector such as a fiber optic end or fiber optic connector. The two other through holes 4, 14 are configured for receiving contact electrodes. Threaded holes 26 are formed transversely to the through holes 3, 4, 14 so as to receive blocking screws. The sample holder has a flat bottom surface 110 generally transverse to the inner flat surface 2 of the holding portion 102. The sample holder also has flat side surfaces 106, 108 generally transverse to the inner flat surface 2 of the holding portion 102 and transverse to the bottom surface 110.

The sample holder 1 is preferably a single-piece of metallic electrically conducting material.

The maximum height H of the sample holder taken along the longitudinal direction of the branches of the U is less than about 10 mm and preferably equal or less than 7 mm. The length L of the sample holder taken along the longitudinal direction of the trench 5 is of about 5 to 40 mm. The thickness T1 of the sample holder in the direction transverse to height H and length L is of about 5 to 40 mm. This sample holder 1 is thus extremely compact.

The width W of the trench 5 between the connecting portion 101 and the holding portion 102 is fixed by construction between 1 and 5 mm, and preferably between 2 and 4 mm. By construction, the depth D of the trench 5 is equal or less than the height H, and preferably comprised between 4 and 6 mm, for a height H of about 7 mm. The trench 5 extends along the direction X across the whole length L of the sample holder. Both ends of the trench are open along the X- direction. The trench 5 is open in one direction along the Z-direction (or height direction) of the sample holder and closed in the opposite direction. The trench enables precise positioning of the sample relatively to the mechanical contact(s), and/or relatively to the electric contact(s) and/or relatively to the illumination light beam. Moreover, the trench enables cross-section measurements of the sample while applying an electric voltage and/or an illumination light beam on a surface of the sample.

According to a particular aspect, the holding portion 102 comprises an insulating coating layer placed on the inner surface 2 and, as necessary on the bottom surface 105 of the trench 5, so as to electrically insulate the sample 10 from the sample holder 1. The material of the insulating coating layer is preferably selected among ceramics so as to withstand high temperature of about 400°C. This insulating coating layer is preferably removable so as to be placed on or removed from the sample holder depending on measurements.

According to another particular aspect, the holding portion 102 comprises a rule extending along the direction X on the upper surface of the holding portion 102. Preferably, this rule is etched into the holding portion 102 and displays a millimetric scale. Such a rule enables precise positioning or repositioning of a sample in the sample holder.

Figures 3 and 4 show the sample holder 1 with contact electrodes 7, 17 placed inside the through holes 4, 14 and the corresponding blocking screws 6. The screw 16 is intended for maintaining a fiber optic connector in the through hole 3. The end of the optical fiber and, respectively, the contact electrodes, are held mechanically by the pressure of screw 6 and, respectively, screws 16. For example, the contact electrodes 7, 17 is a spring probe type contact mounted in an insulating cylinder 8, 18 for electrically insulating the core contact electrode 7, 17 from the sample holder 1. The screw 6 applies a force on the periphery of the cylinder 8, 18 for mechanically maintaining the insulating cylinder 8 and contact electrode 7.

The longitudinal position of each optical or electric connector may be adjusted by sliding the connector within the through hole of the connecting portion 101. The screw 6, respectively 16 in the transverse hole enables mechanically maintaining the electric connector, respectively optical connector 19, in the connecting portion 101. Each connector is easily replaced by another connector, for example connected to another excitation source. Alternative blocking means such as glue may be used instead of blocking screws 6, 16.

Figure 4 shows a sample 10 mounted vertically in the sample holder 1. The sample 10 has a front-side surface 11 and a back-side surface 12 and presents generally a cross-section. In this example, two contact electrodes 7 and 17 apply simultaneously on the front-side surface 11. Thus, the tips of the spring probe contact electrodes 7 and 17 apply a pressure on two areas of the front-side surface 11 of the sample 10. Due to this pressure, the back-side surface 12 of the sample 10 is placed in mechanical contact with the inner surface 2 of the holding portion 102.

The sample 10 mounted in the sample holder 1 may be placed inside a microscope by putting the bottom surface 110, or a side surface 106, 108 on a horizontal surface of the microscope sample stage. The surface on which the sample holder rests thus forms a bearing surface supporting the sample holder. The microscope objective or probe easily approaches the font side surface or cross-section of the sample thanks to the openings of the trench 5.

Alternatively, the sample holder comprises a separate means for mechanically maintaining the surface 2 in contact with the back side 12 of the sample 10. As an example, a blocking screw is mounted in a threaded hole formed in the connecting portion 101, this blocking screw extending in a direction transverse to the surface 2 of the holding portion 102 for applying a pressure on the frontside surface 11 of the sample 10 so as to maintain the backside surface 12 in contact with the surface 2 of the holding portion. Alternatively, the sample holder 1 comprises a mechanical spring for pressing against the frontside surface 11 of the sample so that the backside surface 12 is maintained in contact with the surface 2 of the holding portion 102. The mechanical maintaining means comprising one or several components choses among contact electrode 7 and/or 17 and/or blocking screw and/or mechanical spring are used to maintain the sample 10 so that at least one side of the sample 10 extends above and/or sideways out of the holding portion 102. Such an arrangement, with a sample side protruding out of the trench 5, provides free access for cross-section measurements of the sample, even if the sample dimensions are smaller than the sidewall height U and/or length S. Preferably, the sample 10 is clamped without contacting the bottom surface 105 of the trench 5.

Figure 5 shows a sample 10 mounted vertically in the sample holder 1 according to a variant of the first embodiment. In this example, a first contact electrode 7 applies on the front-side surface 11 and a second contact electrode 17 applies on the inner surface 2 of the holding portion 102. In this configuration, the material of the sample holder 1 is preferably metallic and electrically conducting. Alternatively, the sample holder comprises an electrically conductive layer forming the inner surface 2 of the holding portion 102. In the embodiment illustrated on figure 5, the contact electrodes 7, 17 are preferably of spring probe type contact mounted in an insulating cylinder 8, 18. As detailed in reference to figure 3, screws 6 apply on the periphery of the cylinders 8, 18 for mechanically maintaining the insulating cylinder 8, 18 and contact electrodes 7, 17. Thus, the tip of the spring probe contact electrode 7 applies a pressure on an area of the front-side surface 11 of the sample 10. Due to this pressure, the back-side surface 12 of the sample 10 is placed in mechanical and electrical contact with the inner surface 2 of the holding portion 102. Further, the tip of the spring probe contact electrode 17 applies a pressure on an area of the inner surface 2 of the holding portion 102. Thus, the contact electrode 17 is in electric contact with the back-side surface 12 of the sample 10.

The distance between the two contact electrodes 7 and 17 is fixed by construction. This configuration is suitable for a sample 10 having a front-side electrode area and a backside surface electrode. The sample 10 is easily positioned in the sample holder 1 so that a contact electrode 7 applies a mechanical pressure and an electric energy between the backside surface 12 and a front-side area on the sample 10.

As illustrated on figure 5, the sample comprises a front side electrode in contact with the contact electrode 7 and a backside electrode in contact with the inner surface 2 of the holding portion 102 which is in contact with the other contact electrode 17. Electric cables 37 are connected to the contact electrode 7 or 17 via connectors 27 from a side surface 107 of the connecting portion 101. The two contact electrodes 7, 17 apply simultaneously mechanical pressure and electric voltage to respectively frontside and backside electrode areas on the sample 10. Such a configuration enables cross-section microscopy of the sample 10 while applying controlled electric polarization and electric current to different contact areas of the front side surface 11 and backside surface 12 of the sample 10.

The contact electrodes 7, 17 are thus embedded in the sample holder 1 and remain in fixed positions relatively to the sample holder 1.

Moreover, Figure 5 illustrates a configuration of the sample holder 1 further comprising a fiber optic connector 19 at an end of a fiber optic 9. More precisely, the fiber optic connector 19 is placed in the through hole 3 and maintained using a transverse blocking screw 16. Thus, the fiber optic connector 19 is embedded in the connecting portion 101 and remains in fixed position relatively to the holding portion 102, and relatively to the contact electrodes 7, 17. The end of the fiber optic forms a secondary light source for generating an illumination beam, which is applied directly on the front-side surface 11 of the sample to be analyzed. By construction, the angle of incidence of the illumination beam 29 on the sample surface is about 90 degrees.

On figure 5, the light source is off. The configuration of figure 5 enables cross-section microscopy of the sample 10 while applying electric polarization between the frontside surface and the backside surface and while applying various illumination conditions directed on the front side 11. This sample holder enables measuring electric current-voltage curves as a function of the illumination conditions.

In another operation mode, illustrated on Figure 6, the contact electrode 7 and contact electrode 17 are in contact with two separate areas on the front side surface 11 of the sample. Figure 6 shows a same sample mounted in the same sample holder 1 with the light source on, thus producing an illumination beam 29 on an area of the front side 11.

The configuration of figure 6 enables cross-section microscopy of the sample 10 while electrically polarizing the front side 11 and while directing known illumination conditions on the front side 11. In an exemplary application, this sample holder enables measuring electric current-voltage curves of sample 10 as a function a varying illumination conditions.

In a variant of the first embodiment, the sample holder is used only for investigating the response of the photoelectric device to optical illumination, without applying an electric source of energy. In this case the sample holder 1 comprises a fiber optic connector and mechanical means, such as a screw or a spring, for applying a force in a direction transverse to the inner surface so as to maintain the back side surface 12 of the device in contact with the inner surface 2 of the holding portion 101. The contact electrodes 7, 17 can also be used for applying mechanical pressure while being in open circuit and thus without applying an electric voltage. The contact electrodes thus provide mechanical stability, without any electrical interference.

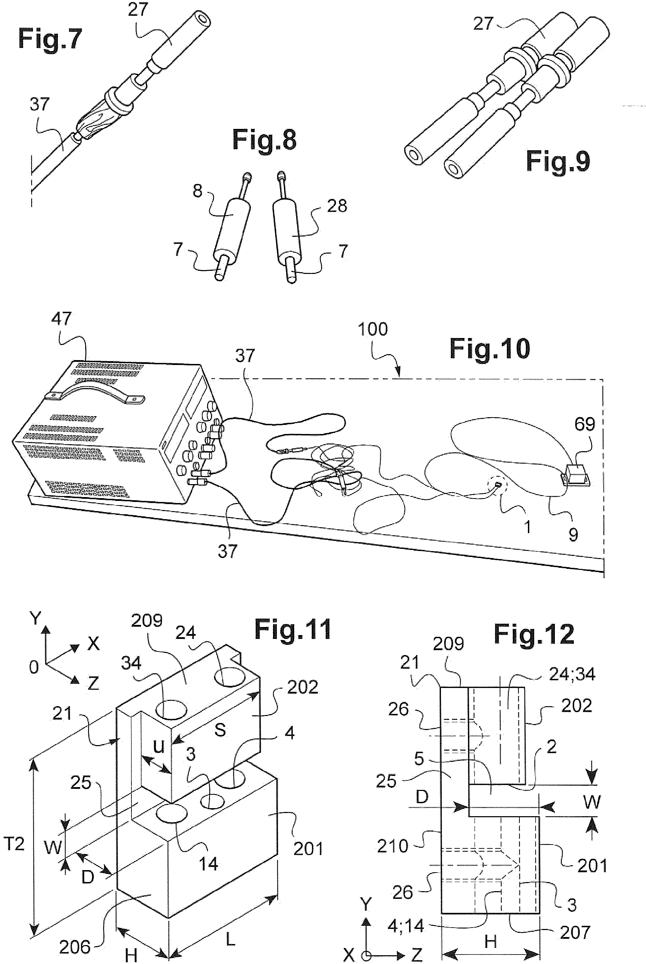

Figure 7 shows a detailed view of the electric cable 37 and connector 27 for connecting to a contact electrode 7 or 17. Figure 9 shows a detailed view of an electric connector 27 which connects electric cable 37 with contact electrode 7. The electric connector 27 comprises preferably a hollow cylinder part with adaptive diameter for receiving and maintaining the contact electrode 7, as shown on figure 9.

Figure 8 shows different types of contact electrodes with plastic type insulator 8 and, respectively, with ceramic-type insulator 28. The contact electrode has a generally cylindrical shape with a circular cross-section and extends along a longitudinal axis. The insulator 8, 28 forms a sleeve surrounding the electrically conducting core contact electrode 7. The outer diameter of the insulator 8, 28 is selected for fitting in the corresponding holes 4, 14 of the connecting portion 101. The end of the contact electrode intended to be in contact with the front side surface 11 or with the surface 2 of the holding portion 102, preferably comprises a spring-type contact applying a force along the longitudinal axis of the contact electrode.

Figure 10 shows an example of a system 100 for measuring a photoelectric device. The system comprises an electric power supply unit 47, electrically connected by cables 37 to a light source 69, for example a white LED optically connected to the sample holder 1 by a fiber optic 9.

Figures 11 and 12 schematically represent a sample holder 21 according to a second embodiment. The sample holder 21 comprises a connecting portion 201 similar to the connecting portion 101 of the sample holder 1 of Figure 1. The sample holder comprises a trench 5 between the connecting portion 201 and a holding portion 202. A sample receiving portion 25 links the connecting portion 201 with the holding portion 202. The trench 5 has a width W and a depth D. The sample holder 21 has a maximum height H. The holding portion 202 comprises an inner holding surface 2 and further comprises connection means, including for example two additional through holes 24, 34 extending opposite to the through holes 4, 14 of the first connecting portion 201. The through holes 24, 34 are configured for receiving contact electrodes to be applied on the back side of the sample 10. The inner holding surface 2 of the holding portion 202 has a height U and a length S. Although the dimension T2 of the sample holder 21 is generally larger than the dimension T1 of the sample holder 1, the sample holder 21 remains compact.

Figure 12 schematically represents the sample holder 21 as viewed from a side. The axis of hole 4 is preferably aligned with the axis of hole 24. Similarly, the axis of hole 14 is preferably aligned with the axis of hole 34.

The sample holder 21 has a flat bottom surface 210 generally transverse to the inner flat surface 2 of the holding portion 202. The sample holder also has a flat side surface 206 generally transverse to the inner flat surface 2 of the holding portion 202 and transverse to the bottom surface 210.

The sample 10 mounted in the sample holder 21 may be placed inside a microscope sample stage by putting it on a bearing surface such as the bottom surface 210 or a side surface 206. A microscope objective or scanning probe easily approaches a frontside surface 11 or cross-section of the sample 10 thanks to the openings of the trench 5.

The configuration of the sample holder 21 enables simultaneous or independent front side electric polarization of the sample and/or back side electric polarization of the sample, without moving the sample in the sample holder 21. This configuration is suited for cross-section analysis of electronic devices having front side and back side electrodes, or two backside electrodes. It enables to apply punctual voltage bias both on the frontside and the backside of the device, or to apply a voltage bias with the two electrodes on the frontside, without grounding the backside. Moreover, the sample holder 21 enables electric polarization on the back side surface 12 while directing illumination on the front side surface 11 of the sample 10.

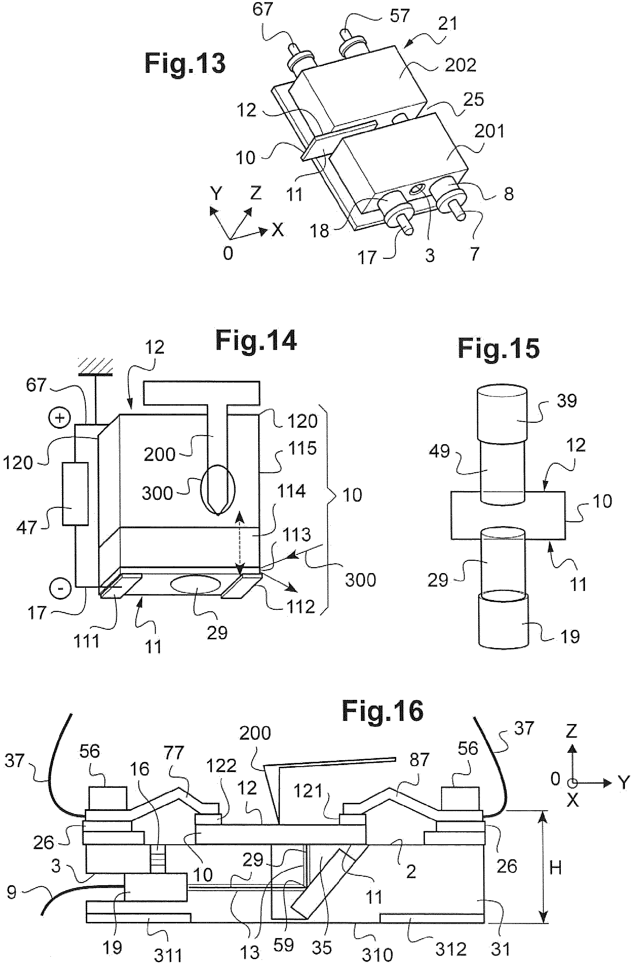

Figure 13 represents a top perspective view of a sample holder 21 according to the second embodiment, with a sample mounted between a pair of contact electrodes comprising a front-side contact electrode 17 and a back-side contact electrode 67. More precisely, the back side surface 12 of the sample 10 is placed against the inner surface 2 of the trench 5. The front side contact electrode 17 placed in the through hole 14 is for example a spring probe type contact, which is maintained using a blocking screw, as described in reference with the first embodiment. The contact electrode 17 applies on the front side surface 11 of the sample 10. A back side contact electrode 67, for example a spring probe type contact, placed in the through hole 23, applies on the back side surface 12 of the sample 10.

In the configuration illustrated on figure 13, only one front side contact electrode 17 and one back side contact electrode 67 are used. However, any of the contact electrodes 7, 17, 57, 67 may be used. More specifically, any combination of two, three, four or more contact electrodes may be selected among these front-side and back-side contact electrodes depending on the sample to be analyzed.

The sample 10 has a lateral dimension (vertical and/or horizontal) so that a cross-section of the sample 10 extends above and/or sideways of the sample holder 21 outside the trench 5. The configuration of figure 13 enables cross-section microscopy of the sample 10 while applying an electric polarization on the front- and back-side surfaces of the sample 10, thus across the sample 10.

Figure 14 schematically shows a method for cross-section microscopy on a solar cell device, with front-side and back-side electrodes in operating conditions, under electric polarization and illumination.

The sample 10 is mounted in a sample holder 21 as illustrated on figure 13. The sample 10 comprises a substrate 115, a back-side electrode 120, and a front-side photo-electric thin film device structure comprising doped semiconducting layers 113, 114 and front-side electrodes 111, 112. The substrate 115 is for example a 500 micrometer thick crystalline silicon wafer. An illumination beam 29 is incident on the front-side surface 11 of the device 10, for example between front-side electrodes 111 and 112. An electric power supply 47 applies an electric polarization to the sample device 10 via contact electrodes 17 and 67, respectively on the front side electrode 111 and backside electrode 120. A near-field scanning probe microscope 200 or an optical microscope is arranged so as to analyze the sample device in cross-section while applying an electric polarization and/or an illumination beam 29 onto the sample. The configuration of the sample holder enables precisely positioning a scanning probe tip 200 and/or probe beam 300 on a cross-section of the sample device, thus enabling micrometric or even sub-micrometric spatial resolution. Positioning of the contact electrodes is easily achieved with sub-millimeter accuracy. Similarly, positioning of the incident illumination beam is easily achieved with sub-millimeter accuracy. The power supply unit may be varied easily, for applying variable or modulated voltage. The primary light source 69 generating the illumination beam 29 may easily be varied according to intensity, wavelength, polarization, without moving the position of the illumination beam 29 on the sample device 10.

The sample holders 1 and 21 thus enable measuring electric and/or optical properties of a thin-film solar cell at the micrometer or nanometer scale as a function of variable electric and/or electro-magnetic excitation sources, with high reliability and repeatability.

The system illustrated on figure 10 may be used in combination with any embodiment of sample holder of the present disclosure, depending on the needs. This system 100 has the advantage of being easily transferred from one microscope setup to another microscope while keeping the same operating conditions of illumination and/or bias voltage. This system 100 enables comparing the performances of a solar cell device in operative conditions when exposed to different light sources, or comparing the electric and/or optical performances of different solar cell devices under the same operative conditions of illumination and electric polarization.

In a variant of the second embodiment, schematically illustrated on Figure 15, double side illumination is applied to a sample device, for example double side solar cell or photodetector, with or without applying an electric voltage. A receiver for receiving another fiber end connector is formed in the holding portion 202 of the sample holder, so as to enables front-side and/or back-side illumination. A first light source, for example a fiber end connector 19, generates a first illumination beam 29 directed from the connection portion 201 to the surface 2 of the holding portion 202. Thus the first illumination beam 29 is incident on the frontside surface 11 of the sample device 10 mounted in the sample holder 21. Another light source, for example a fiber end connector 39, generates a second illumination beam 49 exiting from the portion 202 through the holding surface 2. Thus, the second illumination beam 49 is incident on the backside surface 12 of the sample device 10. This configuration is particularly well suited for analyzing multi-junction or double-side photoelectric devices, such as bifacial solar cells.

If the sample holder is used only for investigating the response of the photoelectric device to optical illumination, without applying an electric source of energy, the contact electrodes may be used for mechanically maintaining the sample. Alternatively, the sample holder 1 comprises mechanical means, such as a screw or a spring, for maintaining the back side surface 12 of the device in contact with the inner surface 2 of the sample holder 1.

Figures 16-18 illustrate different views of a sample holder 31 according to a third embodiment.

Figure 16 schematically shows a cut-view of a sample holder 31. In this third embodiment, the sample holder 31 has an overall flat shape with a bottom surface 310 and a top holding surface 2. Preferably, the bottom surface 310 is plane. The holding surface 2 is in contact with one side, here for example a portion of the front side surface 11 of the sample 10, while the other side, here the backside surface 12 of the sample device 10 is available for surface analysis.

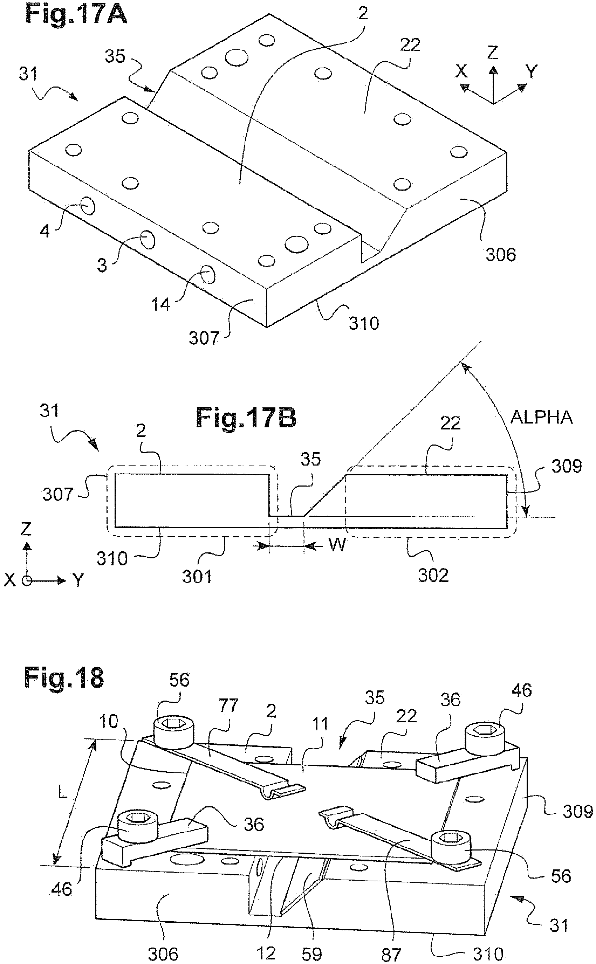

The sample device 10 is for example a device with backside electrodes 121, 122. In the example illustrated on figure 16, the frontside 11 of the device is laid on the holding surface 2 of the sample holder 31 across a trench 35. Contact electrodes 77, respectively 87, are applied onto back side surface electrode 121, respectively 122. The contact electrodes 77, respectively 87 are mechanically maintained on the sample holder 31 using mechanical means, comprising for example blocking nuts 56 and an isolating washer 26. Preferably, the contact electrodes 77, 87 comprise planar spring-type surface contacts. Thus, the contact electrodes 77, 87 apply simultaneously mechanical pressure and electric voltage to corresponding areas on the back-side surface 12 of the sample 10. The mechanical pressure applied by the spring-type contacts 77, 87 contribute to maintaining the front-side 11 of the sample 10 in mechanical contact with the holding surface 2 of the sample holder 31. As an option illustrated on figure 18, mechanical clips 36 and blocking screws 46 are provided for mechanically maintaining the sample 10 in the sample holder 31.

Figures 17A, respectively 17B, illustrates a perspective view, respectively side view, of the sample holder 31 without electrodes, fiber optic connectors and blocking screws. The sample holder 31 has a generally parallelepiped shape with a bottom surface 310 and a top surface 2. The sample holder 31 comprises a first portion 301, a second portion 302 and a sample receiving portion 35 which rigidly links the first portion 301 with the second portion 302. In this embodiment, the first portion 301 has a top surface 2 and the second portion 302 has a top surface 22. Both surfaces 2 and 22 lie in a same plane.

In this embodiment, the first portion 301 may serve as a connecting portion and/or as a holding portion. Here, the first portion 301 comprises a connecting port 3 arranged on a side 307 for receiving an optical fiber connector. Moreover, the first portion 301 comprises a contact electrode 77 arranged on the top surface 2, and, optionally, a clip 36 for mechanically maintaining a sample 10 in contact with the top surface 2. Similarly, the second portion 302 may serve as a connecting portion and/or as a holding portion with connecting port(s) arranged on a side 309 transverse to the bottom side 310. The second portion 302 comprises another contact electrode 87 arranged on the top surface 22, and, optionally, a clip 36 for mechanically maintaining a sample 10 in contact with the top surface 22.

Moreover, the first portion 301 incorporates an illumination system for directing an illumination beam 29 on the front side 11 of the sample device 10. For example, the first portion 301 comprises a hole 3. In the case where the opposite surfaces 2 and 210 are plane and parallel with each other, the hole 3 is cylindrical with a longitudinal axis parallel to the bottom surface 210. The hole 3 is dimensioned to receive a fiber optic end connector 19. The inner diameter of hole 3 is adapted to the outer diameter of the fiber end connector 19.

Further, the receiving portion 35 forms a trench between the top surface 2 of the first portion 301 and the top surface 22 of the second portion 302. This trench extends along the X-direction from one side surface 306 to the opposite side surface across the whole length L of the sample holder. The receiving portion 35 has a profile cut with one side inclined at an angle ALPHA of 45 degrees with respect to the plane of the bottom surface 310. This inclined surface is intended to receive a plane mirror 59 for reflecting an illumination beam toward the sample surface which lies across the trench 35. The bottom of the receiving portion 35 has a width W. As in the first and second embodiment, the receiving portion 35 is open in one direction along the Z-direction (or height direction) of the sample holder and closed in the opposite direction. The trench 35 enables precise positioning of the sample relatively to the mechanical contact(s) and/or relatively to the electric contact(s) and/or relatively to the illumination light beam. Moreover, the trench 35 enables cross-section measurements of the sample, for example using a near-field probe, while applying an electric voltage and/or an illumination light beam on a surface of the sample.

Preferably, the sample holder 31 is transparent in a spectral range of the illumination light beam 29. When the fiber optic is optically connected to a primary light source, the fiber end connector 19 emits an illumination light beam 29 which is transmitted through the sample holder 31 in a direction parallel to the bottom surface 200 and top surface 2. As illustrated on Figure 16, a hollow conduit 13 is formed in the sample holder 31 for transmitting the illumination beam through the sample holder 31 without absorption. A reflecting surface, for example a ultrathin mirror 59, is arranged in the trench 35 inside the sample holder 31 so as to receive the illumination light beam 29 and to direct this illumination light beam 29 toward the holding surface 2 of the sample holder 31. The sample device 10 is arranged with a front side 11 placed against the holding surface 2. Thus, the front side 11 receives the illumination light beam 29 reflected by the mirror 59 and transmitted through the sample holder 31.

The sample holder 31 is equipped with surface electrodes 77, 87 and with a fiber optic illumination system. Integration of the electric and electro-magnetic sources into the sample holder 31 enables this sample holder 31 to present a limited height H. The overall height H is generally limited to less than 10 millimeters, and preferably less than or equal to 7 mm. Due to this limited height, the sample holder 31 is easily inserted on a microscope sample stage. For example, a microscope scanning probe 200 may be applied for surface analysis of the back-side surface 12 between the electrodes 121, 122. Surface microscopy is thus achieved while applying electric polarization and/or optical illumination of the sample device 10.

The sample holder 31 comprises electric connectors for receiving electric cable connections, the electric connectors being arranged for applying or detecting electric voltage and/or current on a surface of the sample to be analyzed. Further, the sample holder 31 comprises at least one optical connector for receiving fiber optic connections and transmitting an illumination beam inside the sample holder, and the sample holder 31 comprises an inner optical system for directing the illumination beam toward the holding surface of the sample holder, so as to illuminate the side of the sample device in contact with the holding surface 2. In summary, the sample holder 31 comprises a holding surface 2, 22, intended for being in contact with a frontside or backside surface of the sample, contact electrodes arranged for applying or detecting electric voltage and/or current on another side of the sample, an optical connector and an inner optical system for directing the illumination beam toward the holding surface of the sample holder. In this third embodiment, the optical connection portion includes the optical path formed inside the sample holder 31 between the fiber optic connector 19 and the holding surface 2. In this third embodiment, the electric connection portion comprises the contact electrodes 77, 87, which also act as mechanical maintaining means.

The sample holder 31 is thus suitable for scanning probe or electron microscopy or optical microscopy of a surface of a solar cell device in operating conditions. Moreover, the trench 35 forms an aperture enabling to reach the cross-section of the sample for cross-section microscopy.

According to a particular aspect, the sample holder 31 comprises magnetic means, for example magnets 211, 212 for maintaining the sample holder 31 on a microscope sample stage.

The sample holder described in the present disclosure applies in particular for analyzing samples selected among electric, optical or photoelectric devices. Such a sample holder makes the operation of a sample device compatible with cross-section and/or surface microscopy analyses. The various embodiments of sample holders described above may be used for many analyses of photoelectric devices or samples, such as:
- Surface photo-voltage of cleaved junction devices under different conditions of illumination using Kelvin Probe Force Microscopy
- Surface potential on cleaved PN junction devices under varying voltage biases using Kelvin Probe Force Microscopy or Scanning Electron Microscopy.
Surface potential and current measurements between the fingers of interdigitated back contact solar cells using Kelvin Probe Force Microscopy and Conducting Probe Atomic Force Microscopy under varying voltage bias and illumination conditions.

## Claims

1. Sample holder (1, 21, 31) for analyzing a solid sample (10) in a microscope instrument, said solid sample (10) having a front-side surface (11), a back-side surface (12) opposite to the front-side surface and a cross-section (8) extending between the front-side surface (11) and the back-side surface (12), **characterized in that** the sample holder (1,21,31) comprises:
- a first portion (101, 201, 301) and a second portion (102, 202, 302) ;
- a sample receiving portion (5, 25, 35) rigidly linking the first portion (101, 201, 301) to the second portion (102, 202, 302), the sample receiving portion (5, 25, 35) forming a trench between the first portion (101, 201, 301) and the second portion (102, 202, 302), said trench extending along a longitudinal direction (X) ;
- at least one of the first portion (101, 201, 301) and second portion (102, 202, 302) having a holding surface (2, 22) adjacent to the sample receiving portion, said holding surface (2, 22) extending in a plane (X, Y) including said longitudinal direction (X) ;
- the first portion (101, 201, 301) and/or the second portion (102, 202, 302) comprising means for mechanically maintaining said holding surface (2, 22) in contact with a portion of one of the front-side surface (11) or back-side surface (12) of the sample (10),
- the first portion (101, 201, 301) and/or the second portion (102, 202, 302) integrating at least one connector configured for transmitting electric energy and/or electro-magnetic energy generated by an excitation source, to one or several areas of the front-side surface (11) and/or back-side surface (12) of the sample (10),
- said sample holder (1, 21, 31) comprising at least one outer bearing surface (106, 108, 110, 206, 210, 306, 309, 310) arranged for positioning said sample (10) in said microscope instrument for microscopy analysis on said front-side surface (11), back-side surface (12) and/or on said cross-section of the sample (10).

2. Sample holder (1, 21, 31) according to claim 1 wherein the holding surface (2) forms an inner wall of the trench of said sample receiving portion (5, 25, 35).

3. Sample holder (1, 21, 31) according to claim 1 wherein the holding surface (2, 22) forms an outer surface of the first portion (301) and/or of the second portion (302).

4. Sample holder (1, 21, 31) according to any of claim 1 to 3 wherein said outer bearing surface (106, 108, 110, 206, 210, 306, 309, 310) lies in a plane (X, Y) perpendicular to the holding surface (2).

5. Sample holder (1, 21, 31) according to any of claim 1 to 4 wherein said outer bearing surface (310) lies in a plane (X, Y) parallel to the holding surface (2, 22).

6. Sample holder (1, 21, 31) according to any of claim 1 to 5 wherein the first portion (101, 201, 301) comprises an optical receiver (3) adapted for receiving a first fiber optic connector (19), the first fiber optic connector (19) being adapted for being optically connected by fiber optic (9) to a first excitation source and for emitting a first optical beam (29) of electro-magnetic energy and wherein the first portion (101, 201) is adapted for directing the first optical beam (29) perpendicularly to the holding surface (2).

7. Sample holder (31) according to claim 6 further comprising an optical system (59) integrated in the sample holder (31), the optical system (59) being configured for optically transmitting and/or reflecting the optical beam (29) between the first optical receiver (3) and the holding surface (2) through the sample holder (31).

8. Sample holder (1, 21, 31) according to claim 6 or 7, wherein the second portion (202, 302) further comprises a second optical receiver adapted for receiving a second fiber optic connector (39), the second fiber optic connector (39) being adapted for being optically connected by fiber optic (9) to a second excitation source and for emitting a second optical beam (49) of electro-magnetic energy, and wherein the second connecting portion (202) is adapted for directing the second optical beam (49) perpendicularly to the holding surface (2) in opposite direction to the first optical beam (29).

9. Sample holder (1, 21, 31) according to any of claim 1 to 8 wherein the first portion (101, 201, 301) comprises at least a first contact electrode (7, 17, 77), the first contact electrode (7, 17, 77) being configured for electrically connecting an external excitation source of electric energy with an area of the frontside surface (11) or backside surface (12) of the sample (10).

10. Sample holder (1, 21, 31) according to any of claim 1 to 9 wherein the second portion (202, 302) comprises at least a second contact electrode (57, 67, 87), said second contact electrode (57, 67, 87) being configured for electrically connecting another external excitation source of electric energy with another area of frontside surface (11) or backside surface (12) of the sample (10).

11. System for surface and/or cross-section microscopy analysis of a solid sample (10),
**characterized in that** said system comprises :
- a sample holder (1, 21, 31) according to any one of claims 1 to 10 for holding the solid sample (10), and
- at least one excitation source of, respectively electric energy and/or electro-magnetic energy, said excitation source being connected to at least one connector, and
- a microscope configured for receiving the sample holder (1, 21, 31) and for surface and/or cross-section microscopy analysis on the front-side surface and/or back-side surface and/or cross-section of the solid sample (10).

12. Process for surface and/or cross-section analysis of a solid sample (10), said process comprising the steps of:
- mechanically maintaining a holding surface (2) of a sample holder (1, 21, 31) in contact with a front-side surface (11, 12) of the solid sample (10);
- setting at least one excitation source of, respectively electric energy and/or electro-magnetic energy, said excitation source being connected respectively by electric wire or fiber optic to a respective first and/or second portion (101, 201, 202) integrated in the sample holder (1, 21, 31) ;
- emission of said electric energy and/or electro-magnetic energy toward the connecting portion configured for transmitting the electric energy and/or electro-magnetic energy to one or several areas on the front-side surface (11) and/or back-side surface (12) of the solid sample (10), and
- surface and/or cross-section microscopy analysis on the front-side surface (11) and/or back-side surface (12) and/or cross-section of the solid sample (10).
